# EUROPÄISCHE PATENTSCHRIFT

(11) **EP 2 952 612 B1**
(45) Veröffentlichungstag und Bekanntmachung des Hinweises auf die Patenterteilung: **24.08.2016**
(21) Anmeldenummer: 15168895.9
(22) Anmeldetag: 22.05.2015
(51) Int. Cl.: C30B 29/06, C30B 13/08, C30B 13/14, C30B 13/20, C30B 13/30, C30B 11/00, C30B 11/10

(54) **VORRICHTUNG UND VERFAHREN ZUR HERSTELLUNG EINES KRISTALLS AUS HALBLEITERMATERIAL**
APPARATUS AND PROCESS FOR PRODUCING A CRYSTAL OF SEMICONDUCTOR MATERIAL
DISPOSITIF ET PROCÉDÉ DE FABRICATION D'UN CRISTAL À PARTIR D'UN MATÉRIAU SEMI-CONDUCTEUR

(30) Priorität: 06.06.2014 DE 102014210936
(43) Veröffentlichungstag der Anmeldung: 09.12.2015
(73) Patentinhaber: Siltronic AG, 81737 München (DE)
(72) Erfinder: Brenninger, Georg, 84564 Oberbergkirchen (DE); Raming, Georg, 84367 Tann (DE)

(56) Entgegenhaltungen:
- EP-A1- 2 319 961
- EP-A1- 2 692 908
- WO-A1-03/093540
- JP-A- H11 292 682

## Beschreibung

Gegenstand der Erfindung ist eine Vorrichtung und ein Verfahren zur Herstellung eines Kristalls aus Halbleitermaterial. Die Vorrichtung umfasst einen Tiegel und eine Induktionsheizspule, die zum Schmelzen eines Vorrats von Halbleitermaterial und zum Stabilisieren einer Schmelze aus Halbleitermaterial vorgesehen ist, die einen wachsenden Kristall aus Halbleitermaterial bedeckt.

Halbleitermaterial, insbesondere Silizium, wird in großen Mengen in Form von Kristallen benötigt, um daraus elektronische Bauelemente oder Solarzellen herzustellen. Die Kristalle werden in einkristalliner oder polykristalliner Qualität angeboten und mit einem kreisförmigen oder rechteckigen oder einem quadratischen Querschnitt. Unter anderem in der US 2005/0188918 A1 und in der EP 2692908 A1 ist beschrieben, wie Kristalle mit einem Querschnitt hergestellt werden können, der nicht kreisförmig ist.

Zur Herstellung von Einkristallen mit kreisförmigem Querschnitt in industriellem Maßstab werden insbesondere das CZ-Verfahren und das FZ-Verfahren angewendet. Beim CZ-Verfahren wird der Einkristall an einem Impfkristall hängend aus einer Schmelze gezogen, die in einem Tiegel enthalten ist. Zum Erzeugen der Schmelze wird der Tiegel mit Bruchstücken aus Halbleitermaterial gefüllt, und die Bruchstücke werden unter Einsatz einer um den Tiegel angeordneten Widerstandsheizung geschmolzen.

Beim FZ-Verfahren wird unter Einsatz einer Induktionsheizspule eine Zone von geschmolzenem Halbleitermaterial zwischen einem Impfkristall und einem Vorratsstab erzeugt. Die Induktionsheizspule ist eine Flachspule mit einem Spulenkörper, der in der Mitte ein Loch mit einem bestimmten Durchmesser ausbildet. Beim Absenken von Impfkristall und Vorratsstab bewegt sich die Schmelzzone in den Vorratsstab, und vom Vorratsstab geschmolzenes Halbleitermaterial kristallisiert auf dem Impfkristall. Zunächst lässt man einen Halsabschnitt kristallisieren, um versetzungsfreies Halbleitermaterial zu erhalten. Im Anschluss daran wächst ein Einkristall aus Halbleitermaterial zu einem konusförmigen Abschnitt mit zunehmendem Durchmesser und schließlich zu einem zylindrischen Abschnitt mit annähernd gleichbleibendem Durchmesser. Einzelheiten zum FZ-Verfahren sind beispielsweise in der EP 2 679 706 A1 beschrieben.

Es gibt auch Beschreibungen von Verfahren, die dem FZ-Verfahren ähnlich sind, sich aber darin unterscheiden, dass Granulat aus Halbleitermaterial an Stelle eines festen Stabs als Vorrat verwendet wird. Stellvertretend für solche Verfahren kann beispielsweise die US 5,367,981 genannt werden, in der die Herstellung von Einkristallen und Polykristallen beschrieben ist. Es ist bisher nicht gelungen, eines dieser Verfahren in industriellem Maßstab einzusetzen. Ein Grund dafür ist die Schwierigkeit, den Transport der Schmelze aus dem Tiegel zu kontrollieren.

Es ist die Aufgabe der vorliegenden Erfindung Abhilfe zu schaffen und eine Vorrichtung und ein Verfahren vorzuschlagen, die mehr Potenzial haben, zur Herstellung von Kristallen aus Halbleitermaterial in industriellem Maßstab eingesetzt werden zu können.

Gelöst wird die Aufgabe durch eine Vorrichtung zur Herstellung eines Kristalls aus Halbleitermaterial, umfassend einen Tiegel mit einem Tiegelboden und mit einer Tiegelwand, wobei der Tiegelboden eine Oberseite und eine Unterseite und eine Vielzahl von Durchtritts-Öffnungen aufweist, die zwischen der Tiegelwand und einem Zentrum des Tiegelbodens angeordnet sind, und wobei auf der Oberseite und auf der Unterseite des Tiegelbodens Aufwölbungen vorhanden sind; und
eine Induktionsheizspule, die unter dem Tiegel angeordnet ist und zum Schmelzen von Halbleitermaterial und zum Stabilisieren einer Schmelze aus Halbleitermaterial vorgesehen ist, die einen wachsenden Kristall aus Halbleitermaterial bedeckt.

Des Weiteren wird die Aufgabe gelöst durch ein Verfahren zur Herstellung eines Kristalls aus Halbleitermaterial, umfassend das Bereitstellen der genannten Vorrichtung;
das Erzeugen einer Schüttung eines Vorrats aus Halbleitermaterial auf der Oberseite des Tiegelbodens;
unter Einsatz der Induktionsheizspule das Schmelzen von Halbleitermaterial der Schüttung und das Leiten des geschmolzenen Halbleitermaterials von der Oberseite des Tiegelbodens durch die Durchtritts-Öffnungen im Tiegelboden zur Unterseite des Tiegelbodens und unter den Aufwölbungen auf der Unterseite des Tiegelbodens vorbei zu einer Schmelze, die einen wachsenden Kristall aus Halbleitermaterial bedeckt und ein Bereich einer Schmelzzone ist.

Das Verfahren ist derart gestaltet, dass es dem FZ-Verfahren besonders ähnlich ist. Durch Unterschiede zum FZ-Verfahren hervorgerufene Schwierigkeiten treten so in den Hintergrund. Insbesondere die Form und die Beschaffenheit des Tiegels tragen dazu bei. So ragen Bestandteile des Tiegels nicht in das Loch in der Mitte der Induktionsheizspule und nicht in den Bereich der Schmelzzone, der sich unter der Induktionsheizspule befindet und den wachsenden Kristall bedeckt. Vom Vorrat stammendes und geschmolzenes Halbleitermaterial fließt auf einem ähnlichen Weg zur Phasengrenze, an der der Kristall wächst, wie es der Fall ist, wenn als Vorrat ein Vorratsstab verwendet wird. Darüber hinaus wird der Vorrat derart zur Verfügung gestellt, dass Staubentwicklung unterdrückt und Erschütterungen der Schmelzzone und das Spritzen von geschmolzenem Halbleitermaterial vermieden werden. Der eingesetzte Tiegel kann wiederverwendet werden, ohne zuvor aufwändig in Stand gesetzt werden zu müssen.

Als Halbleitermaterial kommen insbesondere Silizium oder Germanium oder Mischungen davon in Betracht. Besonders bevorzugt ist Silizium als Halbleitermaterial. Das Halbleitermaterial wird vorzugsweise in Form von Granulat oder in Form von Bruchstücken eingesetzt oder in Form einer Mischung von Granulat und Bruchstücken. Das Granulat hat vorzugsweise einen mittleren Durchmesser von nicht weniger als 0,2 mm und nicht mehr als 30 mm. Ungeachtet dessen können auch kleinere Partikel des Halbleitermaterials, beispielsweise Halbleitermaterial-Staub, zusammen mit Granulat oder Bruchstücken geschmolzen werden.

Der erfindungsgemäß hergestellte Kristall ist vorzugsweise ein Einkristall oder ein polykristalliner Kristall (Polykristall). Besonders bevorzugt ist ein Einkristall aus Silizium. Der erfindungsgemäß hergestellte Kristall hat einen Querschnitt, der kreisförmig oder quadratisch oder rechteckig ist. Die Form des Querschnitts hängt im Wesentlichen davon ab, ob der wachsende Kristall gedreht wird oder nicht. Wird der wachsende Kristall, wie beim FZ-Verfahren üblich, gedreht, entsteht ein Kristall mit kreisförmigem Querschnitt, der einkristallin oder polykristallin sein kann. Unterbleibt die Drehung können auch Kristalle mit rechteckigem oder quadratischem Querschnitt hergestellt werden, beispielsweise indem geschmolzenes Halbleitermaterial wie in US 2005/0188918 A1 oder in EP 2692908 A1 beschrieben, kristallisiert wird.

Der Tiegel hat einen Tiegelboden mit vorzugsweise kreisförmigem Umfang und eine ihn begrenzende Tiegelwand. Der Durchmesser des Tiegelbodens ist vorzugsweise größer als der Durchmesser des Lochs in der Mitte der Induktionsheizspule. Im Tiegelboden ist eine Vielzahl von Durchtritts-Öffnungen vorgesehen. Die Durchtritts-Öffnungen haben einen Querschnitt, der vorzugsweise kreisförmig ist. Die Durchtritts-Öffnungen können vertikal oder schräg durch den Tiegelboden führen. Im Fall einer schrägen Führung ist eine Schrägstellung bevorzugt, bei der die Längsachsen der Durchtritts-Öffnungen mit zunehmender Entfernung vom Tiegelboden nach unten einen zunehmenden Abstand zur Längsachse des wachsenden Kristalls haben. Haben die Durchtritts-Öffnungen einen kreisförmigen Querschnitt, beträgt der Durchmesser der Durchritts-Öffnungen vorzugsweise nicht weniger als 0,5 mm und nicht mehr als 15 mm, besonders bevorzugt nicht weniger als 0,5 mm und nicht mehr als 6 mm.

Der Tiegelboden hat eine Oberseite und eine Unterseite und auf der Oberseite und der Unterseite sind Aufwölbungen (elevations) vorhanden. Aufwölbungen sind Materialerhebungen, die auf der Oberseite nach oben ragen und auf der Unterseite nach unten ragen. Wegen der Aufwölbungen sind die Oberseite und die Unterseite des Tiegels nicht eben, sondern strukturiert. Die Durchtritts-Öffnungen befinden sich vorzugsweise zwischen den Aufwölbungen. Die Aufwölbungen erstrecken sich vorzugsweise entlang von Bahnen, die sich nicht kreuzen und die kreisförmige oder spiralförmige Muster bilden. Besonders bevorzugt sind Aufwölbungen entlang von Bahnen, die ein Muster von Kreisen bilden, die konzentrisch um das Zentrum des Tiegelbodens liegen. Geeignet sind aber auch Bahnen, die sich kreuzen und beispielsweise rautenförmige oder schachbrettartige Muster bilden. Bevorzugt ist ferner, dass zwischen den Mitten benachbarter Aufwölbungen entlang von Bahnen, die sich nicht kreuzen, ein Abstand besteht, der vorzugsweise nicht weniger als 2 mm und nicht mehr als 15 mm, besonders bevorzugt nicht weniger als 3 mm und nicht mehr als 6 mm beträgt. Der Höhenunterschied zwischen dem höchsten Punkt einer Aufwölbung und dem Rand einer angrenzenden Durchtritts-Öffnung ist vorzugsweise nicht weniger als 0,1 mm und nicht mehr als 5 mm, besonders bevorzugt nicht weniger als 0,5 mm und nicht mehr als 3 mm.

Zwischen Aufwölbungen am äußeren Rand auf der Oberseite und der Unterseite des Tiegelbodens und entsprechenden Aufwölbungen, die radial näher am Zentrum des Tiegelbodens liegen, besteht vorzugsweise ein Gefälle. Das Gefälle hat einen Neigungswinkel von vorzugsweise nicht weniger als 1° und nicht mehr als 45°, besonders bevorzugt nicht weniger als 1° und nicht mehr als 5°.

Vorzugsweise ist auf der Unterseite des Tiegelbodens im Zentrum des Tiegelbodens ein Vorsprung vorhanden, der nach unten ragt und sich über dem Loch in der Mitte der Induktionsheizspule befindet. Der Vorsprung hat beispielsweise eine tropfenförmige Form.

Die Oberseite und die Unterseite des Tiegelbodens und vorzugsweise alle übrigen Flächen des Tiegels bestehen aus einem keramischen Material, das beim Kontakt mit flüssigem Halbleitermaterial temperaturbeständig ist und das flüssige Halbleitermaterial möglichst wenig durch Fremdstoffe verunreinigt. Der Tiegel kann aus einem Grundkörper bestehen, der mit dem keramischen Material beschichtet ist. Der Tiegel kann auch vollständig aus dem keramischen Material bestehen. Mögliche Werkstoffe für den Grundkörper sind bruchfeste und hochtemperaturbeständige Werkstoffe, die sich mit dem keramischen Material beschichten lassen, beispielsweise Metalle und Kohlenstoff. Besonders bevorzugt sind Grundkörper aus Kohlenstoff. Das keramische Material ist bevorzugt ein Material wie Aluminiumoxid (Al₂O₃), Bornitrid (BN), Lanthanhexaborid (LaB₆), Siliziumcarbid (SiC), Siliziumnitrid (Si₃N₄), Yttriumoxid (Y₂O₃), Zirkoniumoxid (ZrO₂) oder Quarz (SiO₂). Besonders bevorzugt ist Siliziumcarbid.

Nachfolgend wird die Erfindung am Beispiel der Herstellung eines Einkristalls aus Silizium mit kreisförmigem Querschnitt näher beschrieben.

Als Vorrat wird Silizium in Form von Granulat oder in Form von Bruchstücken eingesetzt oder in Form einer Mischung von Granulat und Bruchstücken. Granulat sind insbesondere Körner aus polykristallinem Silizium, die in einer Wirbelschicht erzeugt werden. Das Granulat hat vorzugsweise einen mittleren Durchmesser von nicht weniger als 0,2 mm und nicht mehr als 30 mm. Bruchstücke sind erhältlich durch Zerkleinern von beispielsweise Stangen aus polykristallinem Silizium. Die Bruchstücke haben vorzugsweise eine maximale Längenausdehnung von nicht weniger als 0,2 mm und nicht mehr als 30 mm. Der Vorrat wird in Form einer Schüttung im Tiegel bereitgestellt. Die Schüttung wird vorzugsweise um eine Menge an weiteren Vorrat ergänzt. Die ergänzte Menge entspricht vorzugsweise derjenigen, die von der Schüttung geschmolzen wird, um das Wachstum des Einkristalls zu unterhalten. Die zu ergänzende Menge wird vorzugsweise zur Verfügung gestellt, indem man weiteren Vorrat zur Schüttung nachrutschen lässt. Der Vorrat und der weitere Vorrat können neben Silizium auch einen oder mehrere elektrisch aktive Dotierstoffe enthalten.

Die Erfinder haben herausgefunden, dass die Aufwölbungen notwendig sind, um den Transport von flüssigem Silizium zu erleichtern. Fehlen die Aufwölbungen, ist der Transport von flüssigem Silizium beeinträchtigt. Der Grund dafür ist die mäßige Benetzbarkeit des Materials des Tiegelbodens durch flüssiges Silizium. Auf einem flachen Tiegelboden entstehen träge Inseln aus flüssigem Silizium, die kaum Neigung zeigen, zu fließen. Durch die Strukturierung der Oberseite und der Unterseite des Tiegelbodens verbessert sich das Fließverhalten von flüssigem Silizium deutlich. Die Inselbildung wird nicht mehr beobachtet. Geschmolzenes Silizium fließt auf der Oberseite durch die Durchtritts-Öffnungen hindurch und auch über die Aufwölbungen hinweg. Der Teil an geschmolzenem Silizium, der zur Unterseite des Tiegelbodens gelangt und größeren radialen Abstand zum Zentrum des Tiegelbodens hat, fließt, zunächst von Oberflächenspannung in Tiegelbodennähe gehalten, unter den Aufwölbungen vorbei nach innen bis zum Vorsprung im Zentrum der Unterseite des Tiegelbodens und in den Bereich der Schmelzzone, der wegen des verengten Durchmessers der Schmelzzone in diesem Bereich auch Hals der Schmelzzone genannt wird.

Die Art und Weise wie geschmolzenes Material in den Hals der Schmelzzone gelangt, unterscheidet sich nicht grundsätzlich vom FZ-Verfahren. Die Unterseite des Tiegelbodens und das untere Stirnende eines Vorratsstabs sind sich sehr ähnlich. Beide Flächen haben eine vergleichbare Topographie, so dass geschmolzenes Silizium, das über diese Flächen zum Hals der Schmelzzone fließt, gleichartiges Verhalten zeigt.

Die Schüttung an Vorrat auf der Oberseite des Tiegelbodens wird vorzugsweise erzeugt, bevor die Schmelzzone gebildet wird. Besonders bevorzugt ist es, den Vorrat zu einem Schüttkegel auf der Oberseite aufzuhäufen. Bei Bedarf wird weiterer Vorrat zur Schüttung nachdosiert, vorzugsweise indem man weiteren Vorrat zur Schüttung nachrutschen lässt. Zu diesem Zweck wird ein mit weiterem Vorrat gefülltes Rohr an die Schüttung gehalten, so dass der weitere Vorrat zur Schüttung gelangen kann, ohne eine freie Fallstrecke überwinden zu müssen.

Zur Herstellung des Einkristalls wird der Tiegel gedreht, während das Rohr, das weiteren Vorrat zum Nachdosieren enthält, vorzugsweise stationär bleibt. Der Drehsinn der Drehung des Tiegels kann mit dem Drehsinn übereinstimmen, mit dem der wachsende Einkristall gedreht wird. Tiegel und Einkristall können auch gegensinnig gedreht werden. Des Weiteren kann eine Wechseldrehung des Einkristalls oder des Einkristalls und des Tiegels vorgesehen sein. Bei einer Wechseldrehung wird der Drehsinn in zeitlichen Abständen umgekehrt.

Wird ein Tiegel erstmalig verwendet, wird beim Erzeugen der Schüttung auf der Oberseite des Tiegelbodens darauf geachtet, dass die Durchtritts-Öffnungen durch Vorrat blockiert werden. Zweckmäßigerweise geschieht das dadurch, dass zumindest eine erste Schicht der Schüttung, mit der der Tiegelboden bedeckt wird, aus Granulat beziehungsweise Bruchstücken besteht, die zu groß sind, um durch die Durchtritts-Öffnungen fallen zu können. Bei Wiederverwendung eines gebrauchten Tiegels ist eine solche Maßnahme nicht notwendig, weil die Durchtritts-Öffnungen durch erstarrte Restschmelze schon blockiert sind.

Die Induktionsheizspule, die unter dem Tiegel angeordnet ist, wird dazu eingesetzt, von der Schüttung stammenden Vorrat nach und nach zu schmelzen. Der Vorrat kann mit elektrisch aktiven Dotierstoffen dotiert sein, um dessen elektrische Leitfähigkeit zu erhöhen.

Zunächst wird Silizium geschmolzen, um die Kristallisation eines Einkristalls in Gang zu setzen. Am Vorsprung, der vom Zentrum der Unterseite des Tiegelbodens nach unten ragt, sammelt sich geschmolzenes Silizium. Der Impfkristall wird damit in Kontakt gebracht und der Halsabschnitt kristallisiert. Die Menge an Silizium, die dafür und für die Kristallisation des auf dem Halsabschnitt wachsenden Einkristalls benötigt wird, wird unter Einsatz der Induktionsheizspule sukzessive vom Vorrat abgeschmolzen, der als Schüttung auf der Oberseite des Tiegelbodens liegt. Das Volumen der Schüttung bleibt annähernd konstant, weil zum Ausgleich weiterer Vorrat aus dem Rohr zum Nachdosieren nachrutscht. Hat der zylindrische Abschnitt des wachsenden Einkristalls eine vorgesehene Länge erreicht, lässt man noch einen konusförmigen Endabschnitt kristallisieren. Nach dem Abschalten der Induktionsheizspule und dem Entfernen des Einkristalls wird geschmolzenes Silizium, das die Oberseite und die Unterseite des Tiegelbodens benetzt, fest. Der Tiegel befindet sich dann in einem Zustand, in dem er wiederverwendet werden kann, ohne zuvor in Stand gesetzt werden zu müssen. Gleichermaßen kann das Nachdosieren von weiterem Vorrat auch abgebrochen werden und das Wachstum des Einkristalls beendet werden, wenn der Vorrat auf der Oberseite des Tiegelbodens im Wesentlichen aufgebraucht ist. Der Tiegel befindet sich dann in einem Zustand, der dem ungebrauchten Zustand ähnlich ist.

Eine Ausgestaltung der Erfindung wird nachfolgend unter Bezugnahme auf Zeichnungen beschrieben.
Fig.1 zeigt eine schematische Schnittdarstellung durch eine erfindungsgemäße Vorrichtung.
Fig.2 zeigt den Tiegel gemäß Fig.1 in perspektivischer Darstellung.

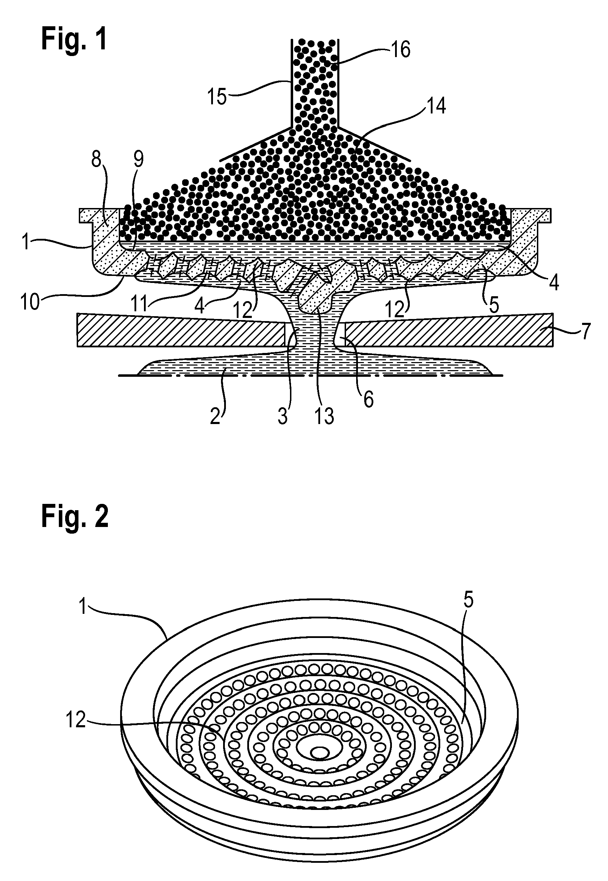

In Fig.1 ist die Vorrichtung mit einem bevorzugt ausgebildeten Tiegel 1 zu einem Zeitpunkt dargestellt, zu dem ein Kristall wächst. Die Schmelzzone gliedert sich in einen Bereich 2, der den wachsenden Kristall bedeckt, in einen Halsbereich 3 und in einen Bereich 4 in Nähe des Tiegelbodens 5. Der Halsbereich 3 der Schmelzzone erstreckt sich durch ein Loch 6 in der Mitte der Induktionsheizspule 7. Die Induktionsheizspule ist zwischen dem Tiegelboden 5 des Tiegels 1 und dem Bereich 2 der Schmelzzone angeordnet, der den wachsenden Kristall bedeckt. Der Tiegel 1 besteht im Wesentlichen aus dem Tiegelboden 5 und der Tiegelwand 8. Der Tiegelboden 5 hat eine Oberseite 9 und eine Unterseite 10 und zwischen der Tiegelwand 8 und dem Zentrum des Tiegelbodens eine Vielzahl von Durchtritts-Öffnungen 11, die durch den Tiegelboden 5 führen. Auf der Oberseite 9 und der Unterseite 10 des Tiegelbodens 5 sind Aufwölbungen 12 vorhanden. Die Durchtritts-Öffnungen 11 liegen zwischen den Aufwölbungen 12. Im Zentrum des Tiegelbodens 5 ragt auf der Unterseite 10 des Tiegelbodens 5 ein Vorsprung 13 nach unten. Auf der Oberseite 9 des Tiegelbodens ist ein Vorrat an festem Halbleitermaterial zu einem Schüttkegel 14 aufgeschüttet. An den Schüttkegel 14 ist eine Einrichtung zum Nachdosieren von weiterem Vorrat herangeführt, mit einem Rohr 15, das mit weiterem Vorrat 16 gefüllt ist.

Wie in Fig.2 dargestellt, hat der Tiegel 1 Aufwölbungen 12, die sich entlang von Bahnen erstrecken, die ein Muster von Kreisen bilden, die konzentrisch um das Zentrum des Tiegelbodens 5 liegen. Die Mitten benachbarter Aufwölbungen 12 haben gleichbleibenden Abstand voneinander.

## Patentansprüche

1. Vorrichtung zur Herstellung eines Kristalls aus Halbleitermaterial, umfassend
einen Tiegel (1) mit einem Tiegelboden (5) und mit einer Tiegelwand, (8), wobei der Tiegelboden eine Oberseite (9) und eine Unterseite (10) und eine Vielzahl von Durchtritts-Öffnungen (11) aufweist, die zwischen der Tiegelwand und einem Zentrum des Tiegelbodens angeordnet sind, und wobei auf der Oberseite und auf der Unterseite des Tiegelbodens Aufwölbungen (12) vorhanden sind; und
eine Induktionsheizspule, (7), die unter dem Tiegel angeordnet istund zum Schmelzen von Halbleitermaterial und zum Stabilisieren einer Schmelze (2)*
aus Halbleitermaterial vorgesehen ist, die einen wachsenden Kristall aus Halbleitermaterial bedeckt.

2. Vorrichtung nach Anspruch 1, **dadurch gekennzeichnet, dass** sich die Aufwölbungen (12) entlang von Bahnen erstrecken, die kreisförmige, spiralförmige, rautenförmige oder schachbrettartige Muster bilden.

3. Vorrichtung nach Anspruch 2, **dadurch gekennzeichnet, dass** zwischen Mitten benachbarter Aufwölbungen (12) von Bahnen, die sich nicht kreuzen, ein Abstand besteht, der nicht weniger als 2 mm und nicht mehr als 15 mm beträgt.

4. Vorrichtung nach einem der Ansprüche 1 bis 3, **dadurch gekennzeichnet, dass** auf der Unterseite (10) des Tiegelbodens (5) im Zentrum des Tiegelbodens ein Vorsprung (13) vorhanden ist, der nach unten ragt und sich über einem Loch (6) in der Mitte der Induktionsheizspule (7) befindet.

5. Vorrichtung nach einem der Ansprüche 1 bis 4, **dadurch gekennzeichnet, dass** die Oberseite (9) und die Unterseite (10) des Tiegelbodens (5) aus keramischem Material bestehen.

6. Verfahren zur Herstellung eines Kristalls aus Halbleitermaterial, umfassend
das Bereitstellen der Vorrichtung nach einem der Ansprüche 1 bis 5;
das Erzeugen einer Schüttung eines Vorrats aus Halbleitermaterial auf der Oberseite des Tiegelbodens;
unter Einsatz der Induktionsheizspule das Schmelzen von Halbleitermaterial der Schüttung und das Leiten des geschmolzenen Halbleitermaterials von der Oberseite des Tiegelbodens durch die Durchtritts-Öffnungen im Tiegelboden zur Unterseite des Tiegelbodens und unter den Aufwölbungen auf der Unterseite des Tiegelbodens vorbei zu einer Schmelze, die einen wachsenden Kristall aus Halbleitermaterial bedeckt und ein Bereich einer Schmelzzone ist.

7. Verfahren nach Anspruch 6, **dadurch gekennzeichnet, dass** die Durchtritts-Öffnungen im Tiegelboden vor dem Schmelzen von Halbleitermaterial der Schüttung durch Halbleitermaterial der Schüttung oder durch erstarrtes Halbleitermaterial blockiert werden.

8. Verfahren nach Anspruch 6 oder Anspruch 7, **dadurch gekennzeichnet, dass** die erzeugte Schüttung des Vorrats aus Halbleitermaterial im Wesentlichen Granulat aus Halbleitermaterial oder Bruchstücke aus Halbleitermaterial oder eine Mischung von Granulat und Bruchstücken aus Halbleitermaterial enthält.

9. Verfahren nach einem der Ansprüche 6 bis 8, **dadurch gekennzeichnet, dass** ein weiterer Vorrat zur Schüttung nachdosiert wird, indem man den weiteren Vorrat zur Schüttung nachrutschen lässt.

10. Verfahren nach einem der Ansprüche 6 bis 9, **dadurch gekennzeichnet, dass** das Halbleitermaterial Silizium ist.

11. Verfahren nach einem der Ansprüche 6 bis 10, **dadurch gekennzeichnet, dass** der Kristall einkristallin oder multikristallin ist.

12. Verfahren nach einem der Ansprüche 6 bis 11, **dadurch gekennzeichnet, dass** der Kristall eine kreisförmige oder rechteckige oder quadratische Querschnittsform hat.

## Claims

1. Apparatus for producing a crystal of semiconductor material, comprising
a crucible (1) comprising a crucible bottom (5) and a crucible wall (8), wherein the crucible bottom has a top surface (9) and an underside (10) and a multitude of openings (11) disposed between the crucible wall and a centre of the crucible bottom and wherein there are elevations (12) disposed on the top surface and the underside of the crucible bottom; and
an induction heating coil (7) which is disposed below the crucible and is provided for melting semiconductor material and stabilizing a melt (2) of semiconductor material covering a growing crystal of semiconductor material.

2. Apparatus according to Claim 1, **characterized in that** the elevations (12) extend along trajectories forming circular, spiral, rhombic or chequered patterns.

3. Apparatus according to Claim 2, **characterized in that** the middles of adjacent elevations (12) disposed along trajectories which do not cross have a distance between them of not less than 2 mm and not more than 15 mm.

4. Apparatus according to any of Claims 1 to 3, **characterized in that** on the underside (10) of the crucible bottom (5) in the centre of the crucible bottom there is a projection (13) which projects downwards and is disposed above a hole (6) in the middle of the induction heating coil (7).

5. Apparatus according to any of Claims 1 to 4, **characterized in that** the top surface (9) and the underside (10) of the crucible bottom (5) consist of ceramic material.

6. Process for producing a crystal of semiconductor material, comprising
providing the apparatus according to any of Claims 1 to 5;
generating a bed of a semiconductor material feed on the top surface of the crucible bottom;
melting semiconductor material of the bed using the induction heating coil and channelling the molten semiconductor material from the top surface of the crucible bottom through the openings in the crucible bottom to the underside of the crucible bottom, passing underneath the elevations on the underside of the crucible bottom, to a melt which covers a growing crystal of semiconductor material and is a region of a melt zone.

7. Process according to Claim 6, **characterized in that** prior to melting semiconductor material of the bed the openings in the crucible bottom are blocked with semiconductor material of the bed or with solidified semiconductor material.

8. Process according to either of Claims 6 and 7, **characterized in that** the generated bed of semiconductor material feed comprises essentially pellets of semiconductor material or chunks of semiconductor material or a mixture of pellets and chunks of semiconductor material.

9. Process according to any of Claims 6 to 8, **characterized in that** the bed is replenished with further feed by allowing further feed to flow down to the bed.

10. Process according to any of Claims 6 to 9, **characterized in that** the semiconductor material is silicon.

11. Process according to any of Claims 6 to 10, **characterized in that** the crystal is monocrystalline or multicrystalline.

12. Process according to any of Claims 6 to 11, **characterized in that** the crystal has a circular, rectangular or square cross section.

## Revendications

1. Dispositif pour la fabrication d'un cristal en un matériau semi-conducteur, comprenant
un creuset (1) avec un fond de creuset (5) et avec une paroi de creuset (8), dans lequel le fond de creuset présente une partie supérieure (9) et une partie inférieure (10) et une pluralité d'ouvertures de passage (11) qui sont disposées entre la paroi de creuset et un centre du fond de creuset, et dans lequel il y a des bombements (12) sur la partie supérieure et sur la partie inférieure du fond de creuset ; et
une bobine de chauffage par induction (7), laquelle est disposée sous le creuset et est prévue pour faire fondre du matériau semi-conducteur et pour stabiliser une masse fondue (2) de matériau semi-conducteur, laquelle recouvre un cristal en croissance en un matériau semi-conducteur.

2. Dispositif selon la revendication 1, **caractérisé en ce que** les bombements (12) s'étendent le long de parcours qui forment des motifs circulaires, en forme de spirale, en forme de losange ou à la manière d'un damier.

3. Dispositif selon la revendication 2, **caractérisé en ce qu'**entre des centres de bombements (12) voisins de parcours qui ne se croisent pas, il existe une distance qui n'est pas inférieure à 2 mm et n'est pas supérieure à 15 mm.

4. Dispositif selon l'une des revendications 1 à 3, **caractérisé en ce que**, sur la partie inférieure (10) du fond de creuset (5), au centre du fond de creuset, il y a une saillie (13) qui dépasse vers le bas et se trouve au-dessus d'un trou (6) au milieu de la bobine de chauffage par induction (7).

5. Dispositif selon l'une des revendications 1 à 4, **caractérisé en ce que** la partie supérieure (9) et la partie inférieure (10) du fond de creuset (5) se composent d'un matériau en céramique.

6. Procédé pour la fabrication d'un cristal en matériau semi-conducteur, comprenant
la mise à disposition du dispositif selon l'une des revendications 1 à 5 ;
la génération d'un lit d'une réserve de matériau semi-conducteur sur la partie supérieure du fond de creuset ;
en utilisant la bobine de chauffage par induction, la fonte du matériau semi-conducteur du lit, et la conduite du matériau semi-conducteur fondu depuis la partie supérieure du fond de creuset en passant à travers les ouvertures de passage dans le fond du creuset jusqu'à la partie inférieure du fond de creuset et sous les bombements sur la partie inférieure du fond de creuset, jusqu'à une masse fondue qui recouvre un cristal en croissance en matériau semi-conducteur et qui est une zone d'une zone de fonte.

7. Procédé selon la revendication 6, **caractérisé en ce que** les ouvertures de passage dans le fond du creuset sont bloquées par du matériau semi-conducteur du lit ou par du matériau semi-conducteur solidifié avant de faire fondre le matériau semi-conducteur du lit.

8. Procédé selon la revendication 6 ou la revendication 7, **caractérisé en ce que** le lit généré de la réserve de matériau semi-conducteur contient essentiellement des granulés de matériau semi-conducteur ou des fragments de matériau semi-conducteur ou un mélange de granulés et de fragments de matériau semi-conducteur.

9. Procédé selon l'une des revendications 6 à 8, **caractérisé en ce qu'**une réserve supplémentaire est ajoutée par dosage au lit en faisant descendre la réserve supplémentaire vers le lit.

10. Procédé selon l'une des revendications 6 à 9, **caractérisé en ce que** le matériau semi-conducteur est du silicium.

11. Procédé selon l'une des revendications 6 à 10, **caractérisé en ce que** le cristal est monocristallin ou polycristallin.

12. Procédé selon l'une des revendications 6 à 11, **caractérisé en ce que** le cristal a une forme en coupe transversale circulaire ou rectangulaire ou carrée.
